**Europäisches Patentamt**

**European Patent Office**

**Office européen des brevets**

(11) Veröffentlichungsnummer: **0 105 998**
**B1**

(12) **EUROPÄISCHE PATENTSCHRIFT**

(45) Veröffentlichungstag der Patentschrift:
08.01.86

(21) Anmeldenummer: **82710047.0**

(22) Anmeldetag: **09.10.82**

(51) Int. Cl.⁴: **H 03 H 17/06, H 04 N 9/78**

(54) Integrierte Schaltung eines Digitalfilters für den Luminanzkanal von Farbfernsehgeräten.

(43) Veröffentlichungstag der Anmeldung:
25.04.84 Patentblatt 84/17

(45) Bekanntmachung des Hinweises auf die Patenterteilung:
08.01.86 Patentblatt 86/2

(84) Benannte Vertragsstaaten:
DE FR GB IT NL

(56) Entgegenhaltungen:
Fernseh- u. Kino-Technik, 1981, Seiten 317-323
Jahrestagungsband der FKTG vom 13.-17. Sept. 1982,
Seiten 392-399
NACHRICHTENTECHNISCHE ZEITSCHRIFT N.T.Z.,
Band 35, Nr. 8, August 1982, Seiten 524-529, Berlin, DE.
M. JACOBSEN et al.: "Digitaler PAL-Decoder für
Farbfernsehempfänger"
PATENTS ABSTRACTS OF JAPAN, Band 3, Nr. 146, 4.
Dezember 1979, Seite 90 E 156

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Baker, Peotr H., Fishpond House, Park Road,
Allington Lincolnshire (GB)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine integrierte Schaltung eines Digitalfilters für den digital arbeitenden Luminanzkanal von Farbfernsehgeräten mit allen Merkmalen des Oberbegriffs des Anspruchs 1.

Ein derartiges Digitalfilter ist aus „Nachrichtentechnische Zeitschrift" („NTZ"), Aug. 1982, Seiten 524 bis 529, insbesondere Bild 2 und 3 bekannt. Dieses ist ein digitales umschaltbares Luminanzfilter, das als Kammfilter ausgebildet ist. Sechs Verzögerungsglieder sind signalflussmässig in Reihe geschaltet, wobei der jeweilige Verbindungspunkt zweier Verzögerungsglieder sowie der Anfang und das Ende der Reihenschaltung je einen Signalabgriff aufweisen. Je zwei zum mittleren Signalabgriff spiegelbildliche Signalabgriffe (z.B. der erste und der letzte) sind auf die Eingänge eines Summierers geschaltet; somit sind drei Summierer angeschlossen. Die Ausgänge der Summierer und der mittlere Signalabgriff liegen an je einem Eingang von vier zugeordneten Multiplizierern, deren zweiten Eingängen einstellbare Multiplizierfaktoren über einen Mikroprozessor zugeführt werden. Die Ausgänge der Multiplizierer liegen an den Eingängen eines Addierers mit vier Eingängen, dessen Ausgangssignal das digitale Luminanzsignal ist. Durch Änderung der Multiplizierfaktoren wird der Frequenzgang des Luminanzfilters für hohe Videofrequenzanteile angehoben oder abgesenkt. Das Luminanzfilter hat einen durch die Änderung der Multiplikatoren nicht beinflussten Dämpfungspol bei der Frequenz des Farbhilfsträgers.

Ein weiteres dazu ähnliches Digitalfilter ist in der Zeitschrift „Fernseh- und Kino-Technik", 1981, Seiten 317 bis 323, insbesondere Bild 4 auf Seite 319 beschrieben. Dieses Digitalfilter enthält eine Teilschaltung aus Verzögerungsgliedern, wobei am Eingang des ersten und am Ausgang des letzten je ein Multiplizierer angeschlossen ist, die die entsprechenden Signale mit dem gleichen Faktor multiplizieren. Die Ausgänge dieser beiden Multiplizierer führen dann zu einem einzigen Addierer mit drei Eingängen, an dessen Ausgang das Luminanzsignal auftritt.

Ferner ist in dem Buch von G. Drechsler „Tagungsband; Manuskripte und Verträge, gehalten auf der 10. Jahrestagung FKTG vom 13. bis 17. September 1982...", Mainz 1982, Seiten 392 bis 399, insbesondere Bild 4, ein digitales adaptives Luminanzkammfilter beschrieben, das zwei Verzögerungsglieder und einen dazwischen angeschlossenen Schaltungsblock „Arithmetik und Umschaltung" enthält. Darin findet eine logische Verknüpfung von benachbarten Farbsignalen zweier aufeinanderfolgender Zeilen statt, und beim Auftreten bestimmter Kriterien wird durch eine interne Funktionsumschaltung das Kammfilter in diesem Bereich der Zeile für den Farbträger gesperrt.

Aus der Schaltungsstruktur der in „NTZ" und in „Fernseh- und Kino-Technik" angegebenen Digitalfilter ergibt sich ohne weiteres, dass das bekannte Digitalfilter Eingangssignale mit der Frequenz null unterschiedlich stark, nämlich in Abhängigkeit vom erwähnten Faktor bewertet. Durch unterschiedliche Wahl dieses Faktors erreichte unterschiedliche Amplitudencharakteristiken haben daher unterschiedliche Gleichanteile. Diese Eigenschaft der bekannten Digitalfilter muss jedoch bei der Verwendung im digitalen Luminanzkanal von Farbfernsehgeräten kompensiert werden, d.h. es ist mindestens ein weiterer Multiplizierer erforderlich, der die erwähnte Abhängigkeit vom jeweiligen multiplikativen Faktor der Filter-Multiplizierer in gegenläufigem Sinne ausgleicht. Dieser zusätzliche Multiplizierer ist in „NTZ", Bild 2 und in „Fernseh- und Kino-Technik", Bild 4 zwar nicht gezeigt, dessen Vorhandensein ergibt sich jedoch zwangsläufig aus den Amplitudencharakteristiken von „NTZ", Bild 3 und „Fernseh...", Bild 5, worin die einzelnen Charakteristiken einen konstanten Gleichanteil haben.

Ausser der Verwendung der erwähnten, in der Teilschaltung enthaltenen Multiplizierer ist also auch der zusätzlich noch vorzusehende Multiplizierer insofern nachteilig, als dadurch die Schaltung insgesamt recht aufwendig wird.

Die Aufgabe der in den Ansprüchen gekennzeichneten Erfindung besteht darin, das bekannte Digitalfilter so zu verbessern, dass insbesondere auf den zusätzlichen, dem Amplitudenausgleich dienenden Multiplizierer verzichtet werden kann, d.h. unterschiedliche Amplitudencharakteristiken sollen nicht durch die unterschiedliche Wahl eines Multiplizierfaktors, sondern durch andere Mittel erreicht werden. Dabei soll jedoch die Eigenschaft der bekannten Schaltung, nämlich konstante Gruppenlaufzeit zu haben, erhalten bleiben. Selbstverständlich soll auch die bekannte Eigenschaft erhalten bleiben, dass das Digitalfilter bei der Referenzträgerfrequenz einen Dämpfungspol (Verstärkungs-Nullstelle) hat, zusätzlich soll es jedoch auch einen Dämpfungspol bei 6 MHz haben, welche Frequenz bei der Typenprüfung von Farbfernsehgeräten durch die Deutsche Bundespost angewendet wird.

Die Erfindung wird nun anhand der Figuren der Zeichnung näher erläutert.

Fig. 1 zeigt in üblicher Digitalfilter-Schaltschema-Darstellung ein Ausführungsbeispiel der Teilschaltung des Digitalfilters nach der Erfindung,

Fig. 2 zeigt verschiedene Amplitudencharakteristiken der Anordnung nach Fig. 1.

Fig. 3 zeigt Amplitudencharakteristiken der Anordnung nach Fig. 1 mit nachgeschaltetem Tiefpass,

Fig. 4 zeigt als anderes Ausführungsbeispiel die Schaltung zweier hintereinandergeschalteter Teilschaltungen für ein Digitalfilter nach der Erfindung, und

Fig. 5 zeigt verschiedene Amplitudencharakteristiken der Anordnung nach Fig. 4 mit nachgeschaltetem Tiefpass.

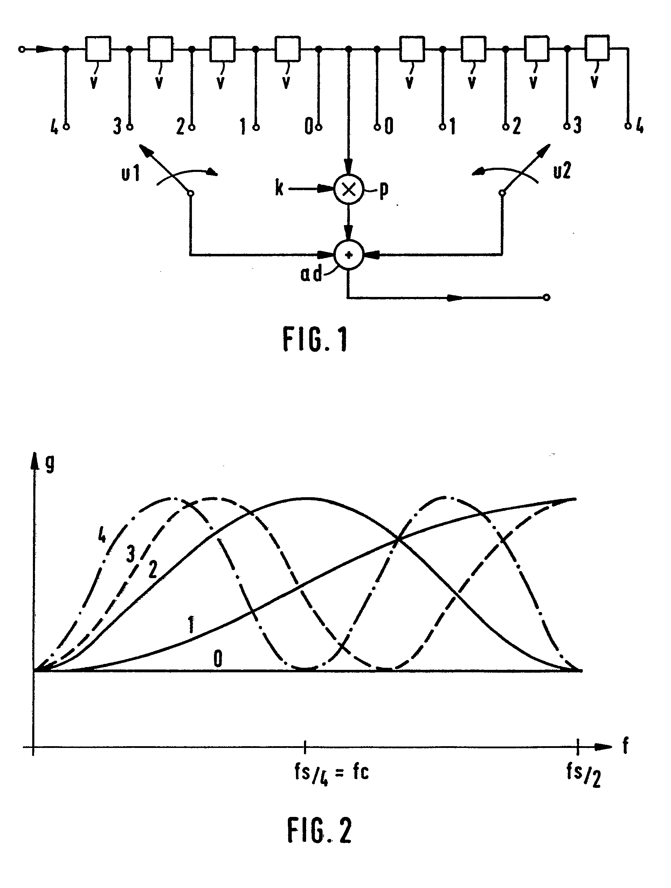

Die Fig. 1 zeigt in üblicher Digitalfilter-Schaltschema-Darstellung die Schaltung eines Ausführungsbeispiels der Teilschaltung für ein Digitalfilter nach der Erfindung. Diese schematische Darstellung besteht darin, dass die für das Filterverhalten wesentlichen Schaltungsteile, nämlich Verzögerungsglieder v, Multiplizierer p und Addierer ad in ihrer für den Signalfluss verantwortlichen Weise miteinander verknüpft sind. Die Verzögerungsglieder v sind dabei bezüglich ihrer Verzögerungszeit als gleich dimensioniert vorausgesetzt, und zwar derart, dass diese Verzögerungszeit gleich der Periodendauer des Taktsignals des Digitalfilters ist. Dieses ist im vorliegenden Fall bei Verwendung im digitalen Luminanzkanal von Farbfernsehgeräten die vierfache Referenzträgerfrequenz fc. In Fig. 1 sind acht Verzögerungsglieder v, also eine gerade Anzahl von Verzögerungsgliedern v, signalflussmässig direkt in Reihe geschaltet, wobei jeder Eingang eines Verzögerungsglieds und der Ausgang des letzten Verzögerungsglieds mit Signalabgriffen versehen sind, die ihrerseits in noch zu schildernder Weise mit den Eingängen der beiden elektronischen Mehrfachumschalter u1, u2 verbunden sind. Der mittlere Signalabgriff der Reihenschaltung der Verzögerungsglieder v, also der zwischen dem vierten und fünften Verzögerungsglied liegende Signalabgriff, ist lediglich aus zeichnerischen Gründen dreifach gezeichnet und führt zum ersten Eingang des einzigen Multiplizierers p, an dessen zweitem Eingang ein einer Konstanten k entsprechendes Signal liegt.

Die Signalabgriffe der eingangsseitigen Hälfte der Verzögerungsglieder v sind, ausgehend vom mittleren Signalabgriff unter dessen Einschluss mit 0, 1, 2, 3, 4 bezeichnet. In dazu spiegelbildlicher Weise sind die Signalabgriffe der ausgangsseitigen Hälfte der Verzögerungsglieder ebenfalls mit 0 ... 4 bezeichnet. Dies sind zugleich auch die Eingänge der beiden elektronischen Mehrfachumschalter u1, u2. Durch Wahl des entsprechenden Signalabgriffs in der ersten und zweiten Hälfte können unterschiedliche Amplitudencharakteristiken eingestellt werden.

Der Ausgang des Multiplizierers p liegt am ersten Eingang und der jeweilige Ausgang des ersten elektronischen Mehrfachumschalters u1 bzw. der des zweiten elektronischen Umschalters u2 am zweiten bzw. dritten Eingang des Addierers ad. Sein Ausgang ist zugleich der Ausgang der Teilschaltung.

Fig. 2 zeigt den Verlauf der Amplitude g über der Frequenz f für die Anordnung nach Fig. 1, wenn die beiden elektronischen Mehrfachumschalter u1, u2 jeweils auf gleich bezifferte Abgriffe eingestellt sind. In Fig. 2 sind die entsprechenden Charakteristiken mit diesen Bezugszeichen versehen. Aus Fig. 2 ist ersichtlich, dass je nach Schalterstellung der elektronischen Mehrfachumschalter u1, u2 bezüglich der Taktfrequenz fs unterschiedliche Charakteristiken vorhanden sind, nämlich dass beispielsweise die Kurve 4 bei der Referenzträgerfrequenz fc und deren Vielfachen ein Verstärkungsminimum hat, während die Kurve 2 bei der Referenzträgerfrequenz fc ein Verstärkungsmaximum und bei deren Doppeltem ein Verstärkungsminimum hat. Diese Eigenschaft kann bei der Realisierung von Digitalfiltern zur Erzeugung von Dämpfungspolen (Verstärkungs-Nullstellen) ausgenutzt werden.

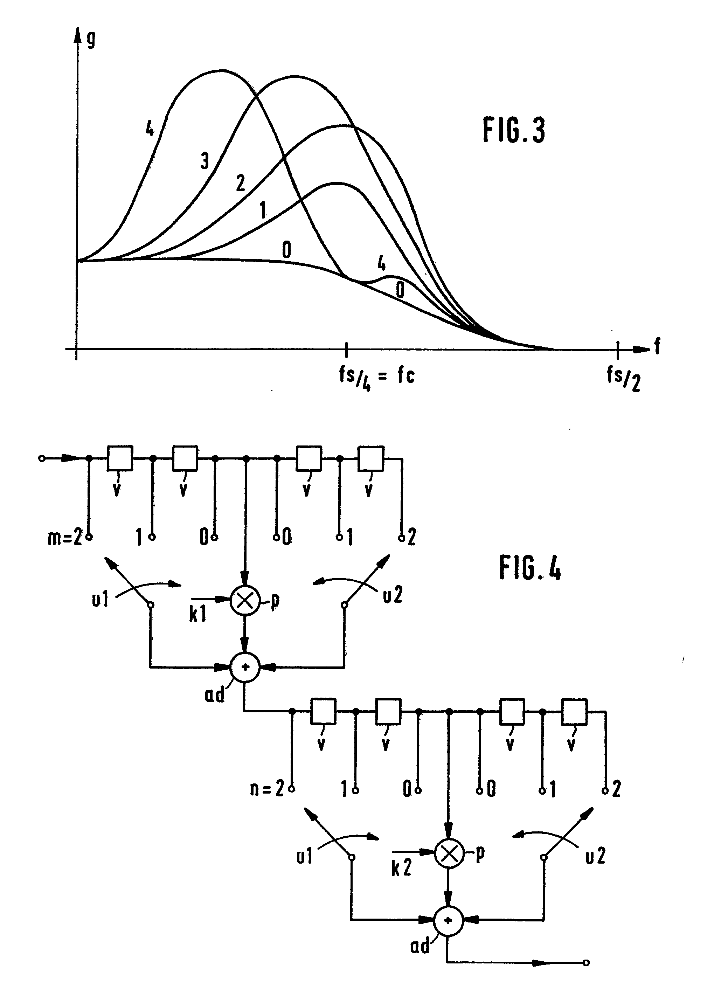

In Fig. 3 sind nochmals Amplitudencharakteristiken gezeigt, die wiederum mittels einer Teilschaltung nach Fig. 1 erzielt werden, der ein digitaler Tiefpass mit einer oberen Grenzfrequenz, die etwa gleich der Referenzträgerfrequenz fc oder kleiner ist, nachgeschaltet ist.

In Fig. 4 ist in Ausgestaltung der Erfindung das Prinzip-Digitalfilter-Schaltbild eines anderen Ausführungsbeispiels gezeigt, bei dem zwei Teilschaltungen der Struktur nach Fig. 1 signalflussmässig hintereinandergeschaltet sind. Die beiden Teilschaltungen sind dabei bezüglich der Anzahl der einzelnen Schaltungsteile und deren Verknüpfung untereinander jeweils identisch, sie unterscheiden sich lediglich durch die Wahl des Multiplizierfaktors voneinander, der bei der eingangsseitigen Teilschaltung in Fig. 4 mit k1 und bei der ausgangsseitigen Teilschaltung mit k2 bezeichnet ist. Diese beiden Faktoren k1, k2 sind also einander nicht gleich.

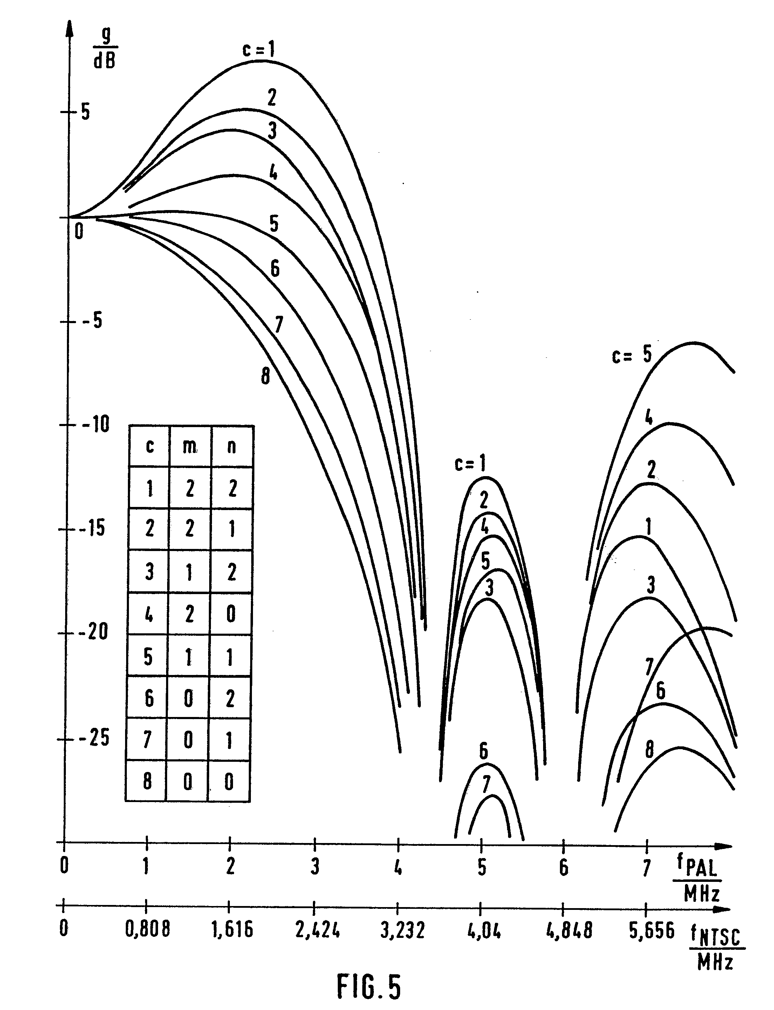

Jede Teilschaltung von Fig. 4 unterscheidet sich von der Anordnung nach Fig. 1 dadurch, dass lediglich vier signalflussmässig direkt in Serie geschaltete Verzögerungsglieder v vorhanden sind und somit die beiden elektronischen Umschalter u1, u2 auch nur solche mit drei Schaltpositionen sind. Diese sind in der eingangsseitigen Teilschaltung mit m und in der ausgangsseitigen mit n bezeichnet. Durch unterschiedliche Einstellung der Schalterpositionen m, n lassen sich bei der Anordnung nach Fig. 4 unterschiedliche Amplitudencharakteristiken erzielen. Wird am Ausgang der zweiten Teilschaltung von Fig. 4 ein digitaler Tiefpass hinzugefügt, so ergeben sich Charakteristiken wie in Fig. 5, die eine Kurvenschar von acht Kurven zeigt, deren Scharparameter c ist. Die einzelnen Kurven ergeben sich laut der in Fig. 5 enthaltenen Tabelle für die dort angegebenen Werte von m bzw. n. In Fig. 5 sind Zahlenwerte für die Ordinate und die Abszisse angegeben. Aus diesen Zahlen, insbesondere denen der Abszisse, ist ersichtlich, dass das Digitalfilter nach der Erfindung durch Wahl des Zahlenwertes der Taktfrequenz fs sowohl für Farbfernsehgeräte nach der europäischen PAL-Norm als auch für solche nach der amerikanischen NTSC-Norm realisierbar ist. Die Fig. 5 zeigt ferner, dass bei der Referenzträgerfrequenz (4,43 MHz bei der PAL-Norm) ein Dämpfungspol besteht. Dieser ergibt sich entsprechend bei der Referenzträgerfrequenz der NTSC-Norm. Die Kurve c = 8, für die m = n = 0 gilt, gibt die Kurve des erwähnten Tiefpassfilters wieder, das für PAL eine obere Grenzfrequenz von etwa 1,70 MHz (für NTSC entsprechend weniger) hat. Dies deshalb, weil im Fall der Kurve c = 8 die Anordnung von Fig. 4 für alle Frequenzen eine konstante Amplitudencharakteristik hat.

Die Zahlenwerte für die Ordinate in Fig. 5 ergeben sich, wenn bei der Anordnung nach Fig. 4 der Faktor k1 = −3 und der Faktor k2 = −6 ist.

Gegenüber dem eingangs erwähnten bekannten Digitalfilter besteht ein Vorteil der Erfindung darin, dass die Signallaufzeit in der Teilschaltung konstant ist, und zwar unabhängig davon, welche Amplitudencharakteristik durch Einstellen der elektronischen Umschalter u1, u2 gewählt wird.

Das Digitalfilter nach der Erfindung kann, wie die Amplitudencharakteristiken zeigen, dazu verwendet werden, im Luminanzkanal eine Kontrast-Hervorhebung (im englischen mit Peaking bezeichnet) zu ermöglichen. Dies bedeutet, dass der Kontrast von sprungartigen Helligkeitsänderungen auf dem Bildschirm erhöht wird, dass also beispielsweise Schwarz-Weiss-Übergänge oder solche von hellen zu dunklen Grauwerten akzentuiert sind. Aufgrund der geschilderten Eigenschaft des Digitalfilters nach der Erfindung, für alle Grade von Kontrast-Erhöhung entsprechend der gewählten Amplitudencharakteristik denselben Gleichwert zu haben, erfolgt jedoch keine Veränderung des Graupegels.

## Patentansprüche

1. Integrierte Schaltung eines Digitalfilters für den digital arbeitenden Luminanzkanal von Farbfernsehgeräten, die mindestens eine Teilschaltung aus einem Addierer (ad) mit mindestens drei Eingängen, aus signalflussmässig hintereinandergeschalteten Verzögerungsgliedern (v), deren Verzögerungszeit identisch und gleich der Periodendauer des Taktsignals des Digitalfilters ist, und mindestens einem Multiplizierer enthält, wobei

— die Eingänge der Verzögerungsglieder (v) sowie der Ausgang des letzten Verzögerungsgliedes Signalabgriffe aufweisen, die paarweise spiegelbildlich zum mittleren Signalabgriff (o) abgegriffen sind,

— der mittlere Signalabgriff (o) am ersten Eingang eines Multiplizierers (p) liegt, dessen zweitem Eingang ein einer Konstanten entsprechendes Signal zugeführt ist und dessen Ausgang am ersten Eingang des Addierers (ad) liegt,

— der Ausgang des Addierers (ad) der Ausgang der Teilschaltung ist

— und die Frequenz (fs) des Taktsignals gleich der vierfachen Referenzträgerfrequenz (fc) ist, gekennzeichnet durch folgende Ausbildung der Teilschaltung:

— jede der eingangsseitigen Hälften der Signalabgriffe ist mit jeweils einem Eingang eines ersten elektronischen Mehrfachumschalters (u1) und jede der ausgangsseitigen Hälften der Signalabgriffe mit jeweils einem Eingang eines zweiten elektronischen Mehrfachumschalters (u2) verbunden, wobei die beiden Mehrfachumschalter (u1, u2) gleichzeitig auf jeweils spiegelbildlich liegende Abgriffe eingestellt sind,

— der Ausgang des ersten Mehrfachumschalters (u1) bzw. der des zweiten Mehrfachumschalters (u2) liegt am zweiten bzw. dritten Eingang des Addierers (ad), der der einzige Addierer der Teilschaltung ist, und

— der Multiplizierer (p) ist der einzige Multiplizierer der Teilschaltung.

2. Integrierte Schaltung nach Anspruch 1, dadurch gekennzeichnet, dass der Teilschaltung ein digitaler Tiefpass nachgeschaltet ist.

3. Integrierte Schaltung nach Anspruch 1, dadurch gekennzeichnet, dass zwei lediglich hinsichtlich der dem Multiplizierer (p) zugeführten Konstanten (k1, k2) unterschiedliche, sonst jedoch identische Teilschaltungen hintereinandergeschaltet sind.

4. Integrierte Schaltung nach Anspruch 3, dadurch gekennzeichnet, dass jede Teilschaltung vier Verzögerungsglieder (v) hat und die Konstanten $k1 = -3$ bzw. $k2 = -6$ sind.

## Claims

1. Integrated circuit of a digital filter for the digital luminance channel of a color-television set comprising a three-input adder (ad), delay elements (v) connected in series in groups of two and each providing a delay equal to the period of the clock signal of the digital filter, and multipliers, with part of the groups of two cascaded, the inputs of the groups of two and the output of the last group of two having taps, and the frequency (fs) of the clock signal being four times the frequency of the chrominance-subcarrier reference (fc), characterized in that the digital filter contains at least one subnetwork with the following features:

— all groups of two are cascaded;

— the junction of the two delay elements (v) of each group of two has a tap as well;

— each of the taps of the half at the input end is connected to an input of a first electronic multiway switch (u1), and each of the taps of the half at the output end is connected to an input of a second electronic multiway switch (u2), the two multiway switches (u1, u2) being simultaneously set to taps which are symmetrical with respect to the center tap (o);

— the center tap (o) is connected to the first input of a single multiplier (p) whose second input is fed with a signal corresponding to a constant (k) and whose output is connected to the first input of the adder (ad), and

— the output of the first multiway switch (u1) and that of the second multiway switch (u2) are connected, respectively, to the second and third inputs of the adder (ad), whose output is the output of the subnetwork.

2. An integrated circuit as claimed in claim 1, characterized in that the subnetwork is followed by a digital low-pass filter.

3. An integrated circuit as claimed in claim 1, characterized in that two subnetworks of the same design are cascaded which differ only in that different constants (k1, k2) are applied to the multipliers (p).

4. An integrated circuit as claimed in claim 3, characterized in that each subnetwork has four delay elements (v), and that the constants $k1 = -3$ and $k2 = -6$.

## Revendications

1. Circuit intégré de filtre numérique destiné au canal de luminance fonctionnant numériquement de téléviseurs couleurs, comprenant au moins un sous-circuit composé d'un additionneur (ad) à au moins trois entrées, d'éléments de retard (v) montés les uns derrière les autres dans le sens du flux de signaux, le temps de retard desdits éléments étant identique et égal à la période du signal de synchronisation du filtre numérique, et d'au moins un multiplicateur, dans lequel :

— les entrées des éléments de retard (v) ainsi que la sortie du dernier élément de retard possèdent des points de prélèvement des signaux qui sont disposés par paires symétriquement par rapport au point central de prélèvement des signaux (o),

— le point central de prélèvement (o) est relié à la première entrée d'un multiplicateur (p) dont la seconde entrée reçoit un signal correspondant à une constante et dont la sortie est reliée à la première entrée de l'additionneur (ad),

— la sortie de l'additionneur (ad) est la sortie du sous-circuit,

— et la fréquence (fs) du signal de synchronisation est égale à quatre fois la fréquence porteuse de référence (fc), caractérisé en ce que le sous-circuit est conçu comme suit :

— chacun des points de prélèvement des signaux de la moitié côté entrée est raccordé à une entrée d'un premier commutateur à positions multiples électronique (u1) et chacun des points de prélèvement des signaux de la moitié côté sortie est raccordé à une entrée d'un second commutateur à positions multiples électronique (u2), les deux commutateurs (u1, u2) étant réglés simultanément sur des points de prélèvement disposés symétriquement,

— la sortie du premier commutateur et, respectivement, celle du second commutateur sont reliées à la seconde et, respectivement, à la troisième entrée de l'additionneur (ad) qui est l'additionneur unique du sous-circuit, et

— le multiplicateur (p) est le multiplicateur unique du sous-circuit.

2. Circuit intégré conforme à la revendication 1, caractérisé en ce qu'un filtre passe-bas numérique est prévu en aval du sous-circuit.

3. Circuit intégré conforme à la revendication 1, caractérisé en ce que deux différents sous-circuits ne se distinguant que par les constantes (k1, k2) envoyées au multiplicateur (p), mais par ailleurs identiques, sont montés l'un derrière l'autre.

4. Circuit intégré conforme à la revendication 3, caractérisé en ce que chaque sous-circuit comporte quatre éléments de retard (v), et en ce que les constantes sont $k1 = -3$ et, respectivement, $k2 = -6$.

FIG.1

FIG.2

FIG.3

FIG.4

FIG.5